# EUROPÄISCHE PATENTANMELDUNG

(11) **EP 4 124 972 A1**
(43) Veröffentlichungstag der Anmeldung: **01.02.2023**
(21) Anmeldenummer: 21187833.5
(22) Anmeldetag: 27.07.2021
(51) Int. Cl.: G06F 16/955

(54) **VERFAHREN ZUR AUTOMATISCHEN BEREITSTELLUNG VON INFORMATIONEN**

(71) Anmelder: Laurini, Frank, 40547 Düsseldorf (DE)
(72) Erfinder: Laurini, Frank, 40547 Düsseldorf (DE)
(74) Vertreter: Rausch, Michael

(57) **Zusammenfassung**

Die Erfindung betrifft eine die aktuellen technischen Möglichkeiten nutzende Symbiose bzw. Kombination der unterschiedlichen Verfahren zur Schaffung eines neuen Informationsmediums. Sie bezieht sich auf die Verwendung eines Verfahrens zur Bereitstellung von ergänzenden Informationen zu Druckerzeugnissen bezüglich Immobilien, welche Druckerzeugnisse eindeutig identifizierbare Elemente aufweisen, wobei Dateien mit ergänzenden Informationen in einer Datenbank gespeichert sind, wobei das Druckerzeugnis mittels eines fototechnischen Verfahrens erfasst und zumindest teilweise digitalisiert wird, wobei die digitalisierten Informationen mittels einer Rechnereinheit zur Erkennung der eindeutig identifizierbaren Elemente analysiert und aufgrund der erkannten Elemente eine Zuordnung des Druckerzeugnisses zu den Dateien erfolgt, wobei aufgrund der Zuordnung der Inhalt der Dateien mit den ergänzenden Informationen bereitgestellt wird, wobei die Verwendung die Präsentation 3 -dimensionaler Darstellungen von Immobilien und Teilen davon umfasst.

## Beschreibung

Die vorliegende Erfindung betrifft ein Verfahren zur automatischen Bereitstellung von Informationen.

Grundsätzlich ist es bekannt, dass aufgrund der digitalen Erfassung von Signalen, insbesondere auf Druckerzeugnissen, ergänzende Informationen bereitgestellt, aus Datenbanken bezogen und gegebenenfalls verarbeitet werden. So gehört es inzwischen zum Alltag, dass beispielsweise an automatischen Kassen lediglich Barcodes oder entsprechende identifizierende Signale fototechnisch erfasst, digitalisiert und analysiert und schließlich verarbeitet werden. Zu den Verarbeitungen gehört beispielsweise, aus zentralen Rechenanlagen Preise zu beschaffen und/oder logistische Daten aus zu lesen oder in Datenbanken einzutragen.

Derartige Vorgänge laufen in aller Regel im Hintergrund. Seit der umfangreichen Verwendung von Smartphones ist es auch bekannt, beispielsweise Codes einzulesen und zur Erlangung ergänzender Informationen zu identifizieren und mittels so genannter Apps zu verarbeiten. So können beispielsweise mittels geeigneter Apps QR-Codes mittels eines Smartphones eingelesen und identifiziert bzw. analysiert werden. Einlesen bedeutet grundsätzlich die Erfassung der bildlichen Vorlage mittels fototechnischer Verfahren, beispielsweise unter Verwendung der Digitalkamera des Smartphones, wobei die jeweilige App ausgelegt ist, den QR Code zu interpretieren und zu analysieren und in Bezug auf konkrete Informationsquellen auszuwerten. Aus diesen Informationsquellen können dann beispielsweise Adressen, Produktinformationen und dergleichen erhalten werden.

Inzwischen werden mehr und mehr Versuche unternommen, bestimmte Informationen in Form zusätzlicher Medien nach dem gleichen Verfahren darzustellen. Hier gibt es verschiedene Grenzen in Bezug auf die Ausstattung der durchschnittlichen Betrachter von Druckerzeugnissen. Druckerzeugnisse im Sinne der vorliegenden Erfindung sind herkömmliche Druckerzeugnisse wie Plakate, Flyer, Poster, Bücher und dergleichen, aber auch deren jeweiligen digitalen Repräsentation, also Textdateien, Bilddateien und dergleichen.

Im letzteren Falle würden die fototechnischen Verfahren und die entsprechend damit zusammenhängende Digitalisierung durch eine einfache digitale Dateianalyse ersetzt, was ebenfalls im Rahmen der Erfindung liegt.

Es wird umfangreich im Bereich der virtuellen Realität und der erweiterten Realität experimentiert, also Präsentationen für Betrachter aus dem Bereich der sogenannten virtuell und/oder augmented reality.

Die vorliegende Erfindung betrifft eine die aktuellen technischen Möglichkeiten nutzende Symbiose bzw. Kombination der unterschiedlichen Verfahren zur Schaffung eines neuen Informationsmediums.

Ausgangspunkt sind Druckerzeugnisse im Sinne der vorliegenden Erfindung, die sich auf Immobilien beziehen. Dies sind große Plakate, Poster, Flyer, aber auch digitale Dateien einschließlich Animationen beispielsweise von geplanten Projekten. Gemeinsam haben all diese als Druckerzeugnis bezeichneten Quellen, dass sie eindeutig identifizierbare Elemente tragen. Dies können herkömmliche Barcodes, QR Codes aber auch völlig neu gestaltete Symbolik und Elemente umfassen. Wesentlich ist hier, dass, ob nun nach fototechnischer Erfassung und Digitalisierung, welche im Übrigen bei Verwendung einer Digitalkamera im gleichen Verfahrensschritt erfolgt, die digitale Analyse die eindeutige Identifizierung der Elemente ermöglicht. Ist das eindeutig identifizierbare Element bekannt, kann automatisch eine Verbindung zu einer entsprechenden Informationsquelle hergestellt werden.

Erfindungsgemäß sind in der Informationsquelle, also einer Datenbank, Dateien enthalten, welche zur erfindungsgemäßen Darstellung von Informationen geeignet sind.

Die gesamte Kommunikation findet auf der Basis des bestehenden Standes der Technik statt. Dazu gehören sämtliche Verbindungsarten wie Funk, Bluetooth, WLAN, LAN und dergleichen. Das Aufnahmegerät, beispielsweise ein Smartphone, erfasst ein wie auch immer geartetes Druckerzeugnis und erkennt die identifizierbaren Elemente. Es tritt nun mit einer lokalen oder einem beliebigen Server, einer cloud oder sonstigen Informationsquellen in Verbindung. Die Informationsquelle liefert aufgrund der übermittelten identifizierbaren Elemente entsprechende Dateien, die auf einem beim Betrachter vorliegenden Gerät darstellbar bzw. wiedergeben, sind. Dieses Gerät kann das gleiche Aufnahmegerät sein, beispielsweise das gleiche Smartphone, es kann sich aber auch um ein zusätzliches Gerät handeln, einen Monitor, einen Rechner oder ein sonstiges displayfähiges Gerät.

Erfindungsgemäß wird der Betrachter nach dem jeweiligen Stand der Technik auch Zusatzgeräte verwenden, beispielsweise 3D Brillen, Brillen für die Präsentation von virtueller oder erweiterter Realität oder sonstige Hilfsmittel.

Erfindungsgemäß wird dem Betrachter nun eine mehrdimensionale, vorzugsweise eine dreidimensionale Darstellung der auf dem Druckerzeugnis repräsentierten Immobilie oder Teilen davon präsentiert. Beispielsweise kann er eine auf dem Druckerzeugnis angebotene Wohnung dreidimensional betrachten, je nach Informationsmedium diese begehen usw. Im Falle einer Projektplanung können beispielsweise technische Details dreidimensional dargestellt werden, beispielsweise der Verlauf von Leitungen, Kabeln, Armierungen und dergleichen.

Durch die Erfindung ergeben sich eine große Vielzahl von neuen Möglichkeiten. Diese beziehen sich zum einen auf die reine Bautechnik, in dem jeweils tiefergehende konkrete Informationen ausgehend von einer überblickartigen Präsentation eingesehen werden können. Ausgehend beispielsweise von der vorliegenden Darstellung eines Hauses können aufgrund einer einfachen Erfassung beliebige technische Details für den Betrachter virtuell und/oder augmented ergänzt werden.

Im Rahmen der Erfindung kann auch vorgesehen sein, dass selbst die dreidimensionalen Ergänzungen ihrerseits eindeutig identifizierbare Elemente aufweisen, die den Betrachter um weitere Ebenen tiefer führen können, indem beispielsweise der aktive Bezug auf konkrete identifizierbare Elemente zu einer Wiederholung des Verfahrens führt und noch tiefergehende Details für den Betrachter sichtbar gemacht werden.

Um das Beispiel weiterzuführen kann auf einem Plakat die Darstellung eines Bauprojektes, beispielsweise eines Wohnhauses, wiedergegeben sein. Zusätzlich sind eindeutig identifizierbare Elemente auf der Darstellung positioniert. Erfasst nun der Betrachter beispielsweise mit seinem Smartphone unter Verwendung einer bereitgestellten App oder sonstigen Software das Plakat, so werden sie eindeutig identifizierbaren Elemente erkannt und zur Weiterleitung an eine vorgegebene Adresse bereitgestellt. Erfolgt die Weiterleitung automatisch oder aufgrund eines vom Betrachter vorgegebenen Befehls, werden von der empfangenden Stelle anhand der eindeutig identifizierbaren Elemente Dateien ausgewählt und an das Gerät des Betrachters übertragen oder beispielsweise zum Download bereitgestellt. Der Betrachter hat nun die Möglichkeit, den Inhalt dieser weiteren Dateien darstellen zu lassen und einzusehen. Dies können Detailzeichnungen, ergänzende Bilder, Videos, Audiodateien oder sonstige beliebige Dateitypen sein, die er mit oder ohne weitere Hilfsmittel einsehen kann.

So kann beispielsweise der Betrachter nunmehr eine konkrete Wohnung des auf dem Druckträger dargestellten Wohnhauses im Detail betrachten, beispielsweise in Form der Begehung einer 3D Animation der Wohnung.

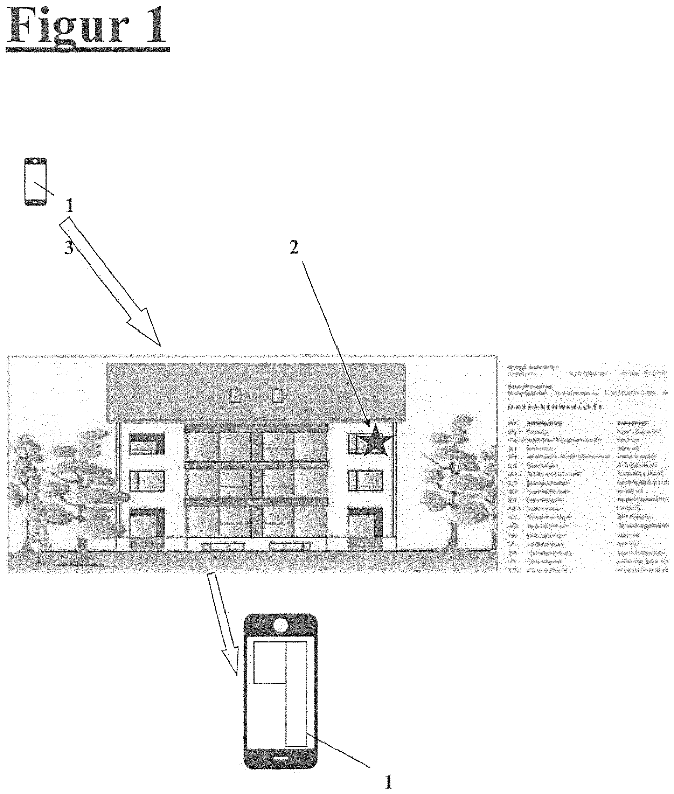

Ein Beispiel wird anhand der Figur 1 erläutert. Diese zeigt ein Smartphone 1, mit welchem eine Fotografie (angedeutet durch Pfeil 3) von einem Bauplakat gemacht wird. Das Bauplakat weist ein eindeutig identifizierbares Element 2 auf. Sobald die Fotografie erstellt und im Smartphone analysiert ist, wird auf dem Smartphone 1 eine Grundriss-Darstellung angezeigt, wie in der unteren Bildebene gezeigt. Dies erfolgt aufgrund der Analyse des eindeutig identifizierbaren Elementes und der entsprechenden Zuordnung zu zentral hinterlegten Dateien. Anstelle von Grundrissen können erfindungsgemäß auch 3D-Darstellungen der Räume und dergleichen angezeigt werden.

Das Beispiel dient nur der Erläuterung und ist nicht beschränkend.

## Patentansprüche

1. Verfahren zur Bereitstellung von ergänzenden Informationen zu Druckerzeugnissen mit eindeutig identifizierbaren Elementen, wobei Dateien mit ergänzenden Informationen in einer Datenbank gespeichert sind, wobei das Druckerzeugnis mittels eines fototechnischen Verfahrens erfasst und zumindest teilweise digitalisiert wird, wobei die digitalisierten Informationen mittels einer Rechnereinheit zur Erkennung der eindeutig identifizierbaren Elemente analysiert und aufgrund der erkannten Elemente eine Zuordnung des Druckerzeugnisses zu den Dateien erfolgt, wobei aufgrund der Zuordnung der Inhalt der Dateien mit den ergänzenden Informationen bereitgestellt wird.

2. Verfahren nach Anspruch 1, **dadurch gekennzeichnet, dass** die Dateien mit den ergänzenden Informationen Videodateien sind.

3. Verfahren nach einem der vorgehenden Ansprüche, **dadurch gekennzeichnet, dass** die Dateien mit den ergänzenden Informationen 3-dimensionale Bilddarstellungen sind.

4. Verfahren nach einem der vorgehenden Ansprüche, **dadurch gekennzeichnet, dass** die identifizierbaren Elemente Kodierungen sind.

5. Verfahren nach einem der vorgehenden Ansprüche, **dadurch gekennzeichnet, dass** die identifizierbaren Elemente auf dem Druckerzeugnis positionierte Bildelemente sind.

6. Verfahren nach einem der vorgehenden Ansprüche, **dadurch gekennzeichnet, dass** die Einheit zur fototechnischen Erfassung und die Rechnereinheit durch ein Smartphone realisiert sind.

7. Verfahren nach einem der vorgehenden Ansprüche, **dadurch gekennzeichnet, dass** zur Analyse eine Software in Form einer App verwendet wird.

8. Verfahren nach einem der vorgehenden Ansprüche, **dadurch gekennzeichnet, dass** die ergänzenden Informationen als Informationen aus dem Bereich der erweiterten Realität ausgebildet werden.

9. Verfahren nach einem der vorgehenden Ansprüche, **dadurch gekennzeichnet, dass** die Druckerzeugnisse Immobilien betreffen und als ergänzende Informationen nach der fototechnischen Erfassung, Digitalisierung und Analyse 3-dimensionale Detailansichten der Immobilie übermittelt werden.

10. Verwendung eines Verfahrens zur Bereitstellung von ergänzenden Informationen zu Druckerzeugnissen bezüglich Immobilien, welche Druckerzeugnisse eindeutig identifizierbare Elemente aufweisen, wobei Dateien mit ergänzenden Informationen in einer Datenbank gespeichert sind, wobei das Druckerzeugnis mittels eines fototechnischen Verfahrens erfasst und zumindest teilweise digitalisiert wird, wobei die digitalisierten Informationen mittels einer Rechnereinheit zur Erkennung der eindeutig identifizierbaren Elemente analysiert und aufgrund der erkannten Elemente eine Zuordnung des Druckerzeugnisses zu den Dateien erfolgt, wobei aufgrund der Zuordnung der Inhalt der Dateien mit den ergänzenden Informationen bereitgestellt wird, wobei die Verwendung die Präsentation 3-dimensionaler Darstellungen von Immobilien und Teilen davon umfasst.
